# EUROPÄISCHE PATENTANMELDUNG

(11) **EP 1 906 723 A2**
(43) Veröffentlichungstag der Anmeldung: **02.04.2008**
(21) Anmeldenummer: 07117023.7
(22) Anmeldetag: 24.09.2007
(51) Int. Cl.: H05K 13/04

(54) **Verschiebeeinrichtung für eine Bauelement-Haltevorrichtung mit zentraler Krafteinleitung**

(30) Priorität: 28.09.2006 DE 102006046028
(71) Anmelder: SIEMENS AKTIENGESELLSCHAFT, 80333 München (DE)
(72) Erfinder: Andersch, Walter, 85551, Kirchheim (DE)

(57) **Zusammenfassung**

Es wird eine Verschiebevorrichtung für eine Haltevorrichtung (220) für elektronische Bauelemente (225) beschrieben. Die Verschiebevorrichtung (207a, 207b) weist auf ein Grundelement (208), ein Linearführungselement (260), welches an dem Grundelement (208) angeordnet ist, und einen länglichen Schaft (265), welcher entlang seiner Längsachse (266), die parallel zu einer z-Achse ausgerichtet ist, in einer Öffnung des Linearführungselements (260) verschiebbar gelagert ist. Die Verschiebevorrichtung (207a, 207b) weist ferner auf einen Linearantrieb (275), welcher an dem Grundelement (208) angeordnet ist und welcher zum Verschieben des länglichen Schafts (265) entlang der z-Achse eingerichtet ist, und ein Koppelelement (280), welches zwischen dem Linearantrieb (275) und dem länglichen Schaft (265) angeordnet ist. Das Koppelelement (280) ist derart ausgebildet, dass von dem Linearantrieb (275) auf den länglichen Schaft (265) lediglich Kräfte entlang der z-Achse übertragbar sind. Das Koppelelement kann eine Kugel (280) sein, die durch eine von einer Rückstellfeder ausgeübten Federkraft (285) an eine plane Stirnfläche (267) des länglichen Schafts (265) oder eines Antriebsstößels des Linearantriebs gedrückt wird.

## Beschreibung

Die Erfindung betrifft das Gebiet der automatischen Bestückung von Bauelementeträgern mittels Bestückvorrichtungen, welche einen Bestückkopf zum temporären Halten von Bauelementen aufweisen, so dass bei einer entsprechenden Bewegung des Bestückkopfes die Bauelemente aufgenommen, transportiert und auf einem Bauelementeträger aufgesetzt werden können. Die vorliegende Erfindung betrifft insbesondere eine Verschiebevorrichtung für eine Haltevorrichtung für elektronische Bauelemente, welche mittels eines geeigneten Antriebs relativ zu einem Grundelement der Verschiebevorrichtung entlang einer Verschiebeachse bewegt werden kann.

Die vorliegende Erfindung betrifft ferner einen Bestückkopf zum automatischen Bestücken von Bauelementeträgern mit elektronischen Bauelementen, welcher Bestückkopf zumindest eine Verschiebevorrichtung der oben genannten Art aufweist, so dass die Bauelement-Haltevorrichtung relativ zu einem Gehäuse des Bestückkopfes entlang einer z-Achse gezielt verschiebbar ist.

Außerdem betrifft die vorliegende Erfindung eine Vorrichtung zum automatischen Bestücken von Bauelementeträgern mit elektronischen Bauelementen, welche Bestückvorrichtung zumindest einen Bestückkopf der oben genannten Art aufweist.

Aufgrund der zunehmenden Miniaturisierung von elektronischen Baugruppen werden an die Bestückgenauigkeit von modernen Bestückvorrichtungen bzw. Bestückautomaten hohe Anforderungen gestellt. Mittels Bestückautomaten werden elektronische Bauelemente auf einen elektronischen Bauelementeträger wie beispielsweise eine Leiterplatte, ein Substrat oder einen sonstigen Schaltungsträger platziert. Dabei wird typischerweise ein in einer xy-Ebene positionierbarer Bestückkopf verwendet, mit dem Bauelemente von einer Abholposition einer Bauelement-Zuführeinrichtung hin zu einer Bestückposition transportiert und an vorgegebenen Einbauplätzen auf den Bauelementeträger aufsetzt werden können. Für eine hohe Bestückgenauigkeit ist neben einem genauen Positioniersystem auch ein Bestückkopf erforderlich, mit die Bauelemente genau an vorgegebenen Einbaupositionen auf einen Bauelementeträger aufgesetzt werden können.

Um sowohl bei der Aufnahme eines Bauelements von einer Bauelement-Zuführeinrichtung als auch bei einem Aufsetzen des Bauelements auf einen Bauelementeträger nicht den gesamten Bestückkopf entlang einer zu der Bestückebene senkrechten z-Richtung bewegen zu müssen, ist die Haltevorrichtung eines Einfach-Bestückkopfes bzw. sind die Haltevorrichtungen eines Mehrfach-Bestückkopfes relativ zu einem Gehäuse des Bestückkopfes entlang der z-Richtung verschiebbar. Im Falle eines Mehrfach-Bestückkopfes können die Bauelement-Haltevorrichtungen entweder mittels eines gemeinsamen z-Antriebs oder mittels individueller z-Antriebe verschoben werden. Bei einem gemeinsamen z-Antrieb ist es möglich, dass durch eine selektive Ankopplung von einzelnen Haltevorrichtungen an den z-Antrieb lediglich eine oder einige wenige Haltevorrichtungen bewegt werden.

Aus der Druckschrift US 4,611,397 ist ein Bestückverfahren bekannt, bei dem ein elektronisches Bauelement von einer Haltevorrichtung aufgenommen wird. Die Haltevorrichtung ist eine so genannte Saugpipette, die an einem verschiebbar gelagerten Saugröhrchen 80 angeordnet ist. Mittels seitlich neben der Haltevorrichtung angeordneten Zentrierarmen kann das Bauelement relativ zu einer Längsachse der Saugpipette zentriert werden. Wie aus Figur 4 der genannten Druckschrift ersichtlich, wird zur Messung der Aufsetzkraft eines Bauelements ein Piezo-Kraftsensor 110 verwendet. Dieser Piezo-Kraftsensor 110 ist mittels einer Kugel 114 mit einem Kolben 90 gekoppelt, der wiederum über eine Feder 88 mit dem Saugröhrchen 80 gekoppelt ist. Auf diese Weise kann während des Aufsetzvorgangs eines aufgenommenen Bauelements die Aufsetzkraft gemessen und über eine entsprechende Rückkopplung geregelt werden. Die Verschiebung der Saugpipette 64 erfolgt mittels eines seitlich angebrachten z-Antriebs 160, der über einen Antriebsriemen 168 eine Zahnstange 162 entlang der z-Richtung bewegt. Die Zahnstange 162 ist über einen Bügel 112 mit dem Kraftsensor 110 gekoppelt.

Der Erfindung liegt die Aufgabe zugrunde, eine Verschiebevorrichtung für eine Bauelement-Haltevorrichtung zu schaffen, welche auf einfache Weise hergestellt werden kann und welche eine zuverlässige Bewegung der Haltevorrichtung entlang einer Verschieberichtung ermöglicht.

Diese Aufgabe wird gelöst durch die mit den unabhängigen Patentansprüchen beschriebenen Gegenstände. Vorteilhafte Ausführungsformen der vorliegenden Erfindung sind in den abhängigen Ansprüchen beschrieben.

Mit dem unabhängigen Patentanspruch 1 wird eine Verschiebevorrichtung für eine Haltevorrichtung für elektronische Bauelemente beschrieben. Die Verschiebevorrichtung weist auf (a) ein Grundelement, (b) ein Linearführungselement, welches an dem Grundelement angeordnet ist, und (c) einen länglichen Schaft, welcher entlang seiner Längsachse, die parallel zu einer z-Achse ausgerichtet ist, in einer Öffnung des Linearführungselements verschiebbar gelagert ist und welcher an einem Ende zur Aufnahme der Haltevorrichtung eingerichtet ist. Die Verschiebevorrichtung weist ferner auf (d) einen Linearantrieb, welcher an dem Grundelement angeordnet ist und welcher zum Verschieben des länglichen Schafts entlang der z-Achse eingerichtet ist, und (e) ein Koppelelement, welches zwischen dem Linearantrieb und dem länglichen Schaft angeordnet ist, wobei das Koppelelement derart ausgebildet ist, dass von dem Linearantrieb auf den länglichen Schaft lediglich Kräfte entlang der z-Achse übertragbar sind.

Der genannten Verschiebevorrichtung liegt die Erkenntnis zugrunde, dass eine zentrale Krafteinleitung entlang der z-Achse auf den länglichen Schaft eine ungewollte Verkantung bzw. Verkippung des länglichen Schaftes auf effektive Weise verhindert. Dies wird dadurch erreicht, dass die einzelnen Funktionsteile der Verschiebevorrichtung im Hinblick auf deren Achslage weitgehend entkoppelt sind. Unter dem Begriff Achslage ist in diesem Zusammenhang insbesondere der seitliche Versatz zur Verschiebeachse bzw. zur z-Achse und/oder der Winkel zwischen den Funktionsteilen und der z-Achse zu verstehen. Auf diese Weise ist eine einfache Herstellung der Verschiebevorrichtung bzw. eine besonders Kosten sparende Montage eines Bestückkopfes möglich, da bei der beschriebenen Verschiebevorrichtung vergleichsweise große Toleranzen erlaubt sind, ohne dass die Genauigkeit des Bestückkopfes in signifikanter Weise verschlechtert wird.

Das Grundelement kann ein Gehäuse bzw. ein Chassis sein. Dabei kann das Grundelement der Verschiebevorrichtung gleichzeitig das Chassis eines Bestückkopfes sein.

Das Linearführungselement bildet zusammen mit dem länglichen Schaft ein Linearlager, welches insbesondere als Gleitlager oder auch als Luftlager ausgebildet sein kann. Um bei einem Gleitlager die Reibungskräfte zu minimieren, kann das Linearführungselement und/oder der längliche Schaft mit einer geeigneten Beschichtung versehen sein, welche eine gewisse Schmierwirkung aufweist.

Der Linearantrieb ist bevorzugt ein Linearmotor. Der Linearantrieb kann jedoch auch ein Drehantrieb sein, wobei mittels einer dem Drehantrieb nachgeschalteten Mechanik eine Drehbewegung in eine Verschiebebewegung überführt wird.

Als Haltevorrichtung kann beispielsweise eine so genannte Saugpipette verwendet werden, welche über eine Längsbohrung innerhalb des länglichen Schafts selektiv mit einem Unterdruck beaufschlagt werden kann, so dass durch eine gezielte Steuerung des Unterdrucks eine temporäre Halterung eines Bauelements an einer Saugpipette realisiert werden kann.

Gemäß einem Ausführungsbeispiel der Erfindung nach Anspruch 2 weist die Verschiebevorrichtung zusätzlich auf (a) ein Rückstellfederelement, welches den länglichen Schaft relativ zu dem Grundelement in eine Ausgangsstellung drückt, und (b) einen dem Linearantrieb zugeordneten Antriebsstößel, mit dem der längliche Schaft aus seiner Ausgangsstellung entlang der z-Achse auslenkbar ist. Dies hat den Vorteil, das auf besondere einfache und damit auch kostengünstige Weise eine Ankopplung des länglichen Schafts an den Linearantrieb realisiert werden kann. Das Koppelelement ist dabei zwischen dem Antriebsstößel und einer Stirnseite des länglichen Schafts infolge der Federkraft des Rückstellfederelements fixiert.

Gemäß einem weiteren Ausführungsbeispiel der Erfindung nach Anspruch 3 ist das Koppelelement eine Kugel. Dadurch kann auf einfache Weise ein nahezu punktförmiger mechanischer Kontakt zwischen dem Koppelelement und dem Antriebsstößel und/oder zwischen dem Koppelelement und dem länglichen Schaft realisiert werden. Auf diese Weise sind der Antriebsstößel und der längliche Schaft in Bezug auf Drehbewegungen um die Verschiebeachse bzw. um die z-Achse nahezu vollständig entkoppelt.

Um eine ungewollte transversale, d.h. senkrecht zur z-Achse verlaufende Verschiebung der Kugel zu vermeiden, kann die Kugel durch eine geeignete Aussparung gehalten werden. Die Aussparung kann dabei an dem Antriebsstößel und/oder an der Stirnseite des länglichen Schafts ausgebildet sein.

Gemäß einem weiteren Ausführungsbeispiel der Erfindung nach Anspruch 4 weist der Antriebsstößel oder der längliche Schaft eine plane Stirnfläche auf, an der das Koppelelement anliegt. Dies hat den Vorteil, dass zwischen Koppelelement und der planen Stirnfläche auf einfache und trotzdem effektive Weise eine reibungsarme Punktbelastung realisiert werden kann, so dass auch bei einem nicht drehbar gelagerten Antriebsstößel eine weitgehend reibungsfreie Drehung des länglichen Schafts realisiert werden kann. Dies gilt insbesondere dann, wenn als Koppelelement, wie oben beschrieben, eine Kugel verwendet wird. Eine derartige Drehung des länglichen Schafts um die z-Achse ist insbesondere bei Bestückköpfen wichtig, damit ein von einer Bauelement-Haltevorrichtung aufgenommenes Bauelement vor dem Aufsetzen auf einen zu bestückenden Bauelementeträger in eine korrekte Winkellage gedreht werden kann.

Gemäß einem weiteren Ausführungsbeispiel der Erfindung nach Anspruch 5 ist das Linearführungselement eine relativ zu dem Grundelement um die z-Achse drehbar gelagerte Hülse. Ferner wirkt eine Innenkontur des Linearführungselements derart mit einer Außenkontur des längliche Schafts zusammen, dass bei einer Drehung des Linearführungselements um die z-Achse der längliche Schaft in gleicher Weise wie das Linearführungselement um die z-Achse gedreht wird.

Das Zusammenwirken der Innenkontur mit der Außenkontur kann dabei auf einfache und effektive Weise dadurch erreicht werden, dass der längliche Schaft zumindest in einem Längsabschnitt eine von einer Zylindersymmetrie abweichende Form aufweist. Sofern der längliche Schaft aus einer ursprünglich zylindrischen Form hergestellt ist, eignet sich insbesondere ein Anschnitt parallel zur z-Achse, welcher Anschnitt mit einer entsprechenden Abflachung der Öffnung des Linearführungselements derart zusammenwirkt, dass eine verdrehsichere Lagerung des länglichen Schafts in dem Linearführungselement realisiert ist.

Gemäß einem weiteren Ausführungsbeispiel der Erfindung nach Anspruch 6 weist die Verschiebevorrichtung zusätzlich einen Drehantrieb auf, welcher mit dem Linearführungselement über zumindest ein Magnetrad gekoppelt ist. Das Magnetrad kann dabei dem Drehantrieb oder dem Linearführungselement zugeordnet sein. Auch die Verwendung von zwei Magneträdern ist möglich, wobei ein erstes Magnetrad dem Drehantrieb und das zweite Magnetrad dem Linearführungselement zugeordnet ist. Eine magnetische Kopplung zwischen dem Drehantrieb und dem Linearführungselement hat den Vorteil, dass das Linearführungselement weitgehend spielfrei von dem Drehantrieb angetrieben werden kann, so dass eine hohe Drehgenauigkeit gewährleistet werden kann.

Mit dem nebengeordneten Patentanspruch 7 wird ein Bestückkopf zum automatischen Bestücken von Bauelementeträgern mit elektronischen Bauelementen beschrieben. Der Bestückkopf weist zumindest eine Verschiebevorrichtung des oben beschriebenen Typs auf.

Der Bestückkopf wird typischerweise dazu verwendet, die Bauelemente von einer Bauelement-Zuführvorrichtung abzuholen, an jeweils eine vorbestimmte Stelle oberhalb eines Bauelement-Einbauplatzes zu transportieren und an durch entsprechende Bauelement-Anschlussflächen definierte Bauelement-Einbauplätze auf dem Bauelementeträger aufzusetzen. Wie oben bereits erläutert, kann die temporäre Halterung der Bauelemente an dem Bestückkopf mittels so genannter Saugpipetten erfolgen.

Der Bestückkopf kann eine oder auch mehrere Verschiebevorrichtungen aufweisen, so dass mit der Erfindung sowohl ein Einfach-Bestückkopf als auch ein Mehrfach-Bestückkopf realisiert werden kann. Mit einem Mehrfach-Bestückkopf können gleichzeitig mehrere Bauelement transportiert werden. Bei einem Mehrfach-Bestückkopf können die einzelnen Verschiebevorrichtungen und damit auch die einzelnen Bauelement-Haltevorrichtungen beispielsweise zeilenförmig oder auch matrixförmig in einem regelmäßigen Raster angeordnet sein.

Mit dem nebengeordneten Patentanspruch 8 wird eine Vorrichtung zum automatischen Bestücken von Bauelementeträgern mit elektronischen Bauelementen beschrieben. Die Bestückvorrichtung weist zumindest einen Bestückkopf der oben beschriebenen Bauweise auf.

Im Falle der Verwendung von mehreren Bestückköpfen innerhalb einer Bestückvorrichtung kann eine besonders hohe Bestückleistung dadurch realisiert werden, dass insbesondere zwei Bestückköpfe wechselweise arbeiten. Dabei werden mit einem ersten Bestückkopf Bauelemente von zumindest einer Bauelement-Zuführvorrichtung aufgenommen, während andere Bauelement von dem zweiten Bestückkopf auf den zu bestückenden Bauelementeträger aufgesetzt werden.

Weitere Vorteile und Merkmale der vorliegenden Erfindung ergeben sich aus der folgenden beispielhaften Beschreibung derzeit bevorzugter Ausführungsformen. In der Zeichnung zeigen in schematischen Darstellungen
- Figur 1: eine perspektivische Darstellung einer Bestückvorrichtung, welche einen Bestückkopf gemäß einem Ausführungsbeispiel der Erfindung aufweist,
- Figur 2: eine Seitenansicht eines Mehrfach-Bestückkopfes, in der zwei Verschiebevorrichtungen dargestellt sind, wobei eine Verschiebevorrichtung in einer Seitenansicht und die andere Verschiebevorrichtung in einer Schnittansicht dargestellt ist, und
- Figur 3: eine Frontansicht des in Figur 2 dargestellten Mehrfach-Bestückkopfes, in der drei Verschiebevorrichtungen dargestellt sind.

An dieser Stelle bleibt anzumerken, dass sich in der Zeichnung die Bezugszeichen von gleichen oder von einander entsprechenden Komponenten lediglich in ihrer ersten Ziffer unterscheiden.

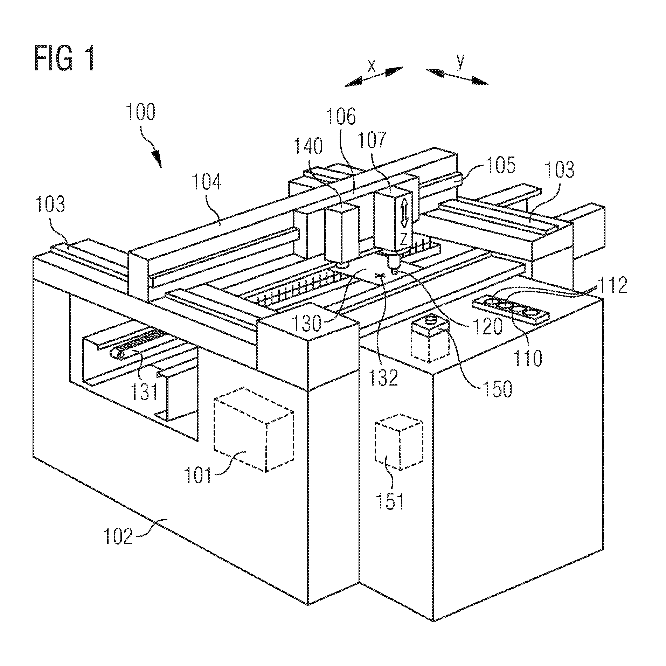

Figur 1 zeigt einen Bestückautomaten 100, welcher einen Rahmen 102 aufweist, an dem zwei parallel ausgerichtete stationäre Linearführungen 103 angebracht sind. Die beiden Führungen 103 tragen einen quer stehenden Trägerarm 104. Der quer stehende Trägerarm 104 weist selbst eine lediglich schematisch dargestellte Linearführung 105 auf, an welcher ein Halteelement 106 verschiebbar gelagert ist. Die beiden Linearführungen 103 verlaufen entlang einer y-Richtung, die Linearführung 105 verläuft entlang einer x-Richtung.

An dem Halteelement 106 ist ein Bestückkopf 107 befestigt, welcher zumindest eine Bauelement-Haltevorrichtung 120 aufweist. Gemäß dem hier dargestellten Ausführungsbeispiel ist die Haltevorrichtung eine Saugpipette 120, die mittels eines nicht dargestellten Antriebs entlang einer zu der x- und zu der y-Richtung senkrechten z-Richtung verschiebbar ist.

Um die Winkellage von aufgenommenen Bauelementen zu korrigieren und um damit die Bauelemente in einer korrekten Orientierung bestücken zu können, ist ferner ein in Figur 1 nicht dargestellter Drehantrieb vorgesehen. Mittels des Drehantriebs kann die Saugpipette 120 um ihre Längsachse bzw. um die z-Achse gedreht werden.

Der Bestückautomat 100 weist ferner eine Bauelement-Zuführeinrichtung 110 auf, über welche in Figur 1 nicht dargestellte Bauelemente dem Bestückprozess an Bauelement-Abholpositionen 112 zugeführt werden können. Ferner umfasst der Bestückautomat 100 ein Förderband 131, mit dem ein Bauelementeträger bzw. eine Leiterplatte 130 in den Bestückbereich eingebracht werden kann. Die Saugpipette 107 kann durch eine entsprechende Bewegung des Bestückkopfes 107 parallel zu der xy-Ebene innerhalb des gesamten Bestückbereichs positioniert werden.

Der Bestückautomat 100 weist außerdem einen Prozessor bzw. eine Datenverarbeitungseinrichtung 101 auf. Auf der Datenverarbeitungseinrichtung 101 kann ein Bearbeitungsprogramm für den Bestückautomaten 100 zum Bestücken von Leiterplatten 130 mit Bauelementen ausgeführt werden, so dass alle Komponenten des Bestückautomaten 100 in synchronisierter Weise arbeiten und somit zu einem fehlerfreien und zügigem Bestücken von Leiterplatten 130 mit Bauelementen beitragen.

An dem Halteelement 106 ist zusätzlich eine sog. Leiterplatten-Kamera 140 befestigt, welche zur Erfassung von zumindest einer an der Leiterplatte 130 angebrachten Markierung 132 vorgesehen ist. Auf diese Weise kann die genaue Position der in den Bestückbereich eingebrachten Leiterplatte 130 durch eine Lagevermessung der Markierung 132 innerhalb des Gesichtsfeldes der Leiterplatten-Kamera 140 bestimmt werden.

Zur Positionsvermessung und zur Kontrolle von aufgenommenen Bauelementen ist eine Kamera 150 vorgesehen, welche gemäß dem hier dargestellten Ausführungsbeispiel in einer festen Position an dem Bestückautomaten 100 angeordnet ist. Die optische Bauelement-Vermessung erfolgt bevorzugt unmittelbar nach der Aufnahme des Bauelements von der Bauelement-Zuführeinrichtung 110 durch eine entsprechende Positionierung des Bestückkopfes 107 oberhalb der Bauelemente-Kamera 150. Das von der Kamera 150 aufgenommene Bild wird in einer Auswerteeinheit 151 ausgewertet und dabei die Lage des aufgenommenen Bauelements relativ zu der Saugpipette 120 ermittelt.

Die Auswerteeinheit 151 kann auch in der Datenverarbeitungseinrichtung 101 integriert sein. Dabei kann die Auswerteeinheit 151 mittels einer eigenen Hardware oder auch mittels einer geeigneten Software realisiert sein.

Es wird darauf hingewiesen, dass die Erfindung keineswegs auf die Verwendung in dem hier dargestellten Bestückautomaten 100 beschränkt ist. Die Erfindung kann beispielsweise auch mit einer Bauelemente-Kamera realisiert werden, welche zusammen mit dem Bestückkopf verfahren wird und welche dafür vorgesehen ist, die aufgenommenen Bauelemente während des Transports von der Aufnahmeposition 112 hin zu der Bestückposition zu vermessen.

Ebenso kann die Erfindung im Zusammenhang mit einem sog. Mehrfach-Bestückkopf eingesetzt werden, welcher mehrere Haltevorrichtungen aufweist und somit gleichzeitig mehrere Bauelemente transportieren kann. Dabei können die Haltevorrichtungen zeilen- bzw. matrixartig angeordnet sein. Selbstverständlich kann die Erfindung jedoch auch mit beliebigen anderen Arten von Einfach- oder Mehrfach-Bestückköpfen realisiert werden.

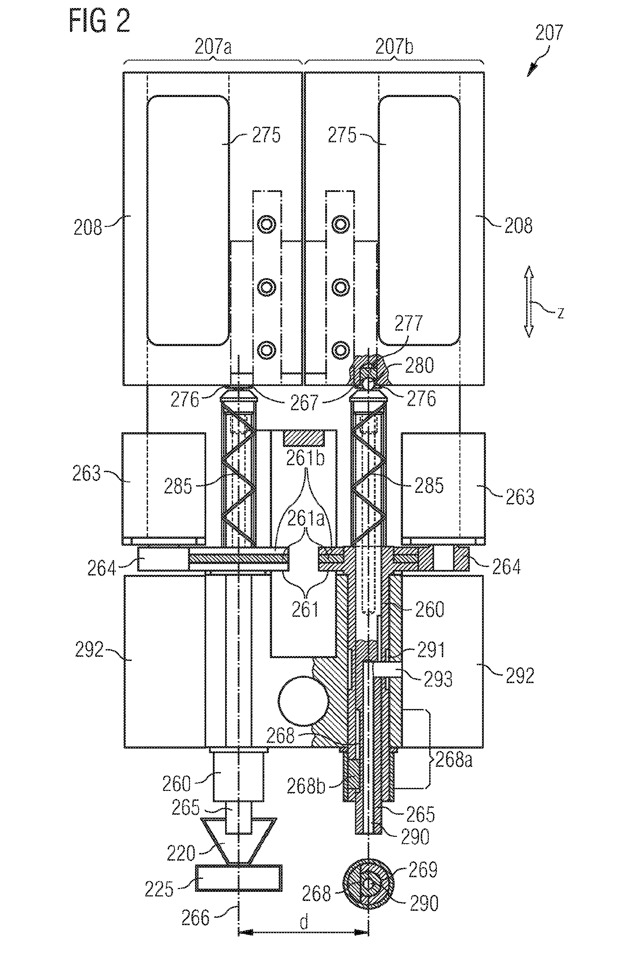

Figur 2 zeigt eine Seitenansicht eines Bestückkopfes 207 gemäß einem Ausführungsbeispiel der Erfindung. Der Bestückkopf 207 ist ein Mehrfach-Bestückkopf, bei dem Bauelement-Haltevorrichtungen in einer regelmäßigen matrixförmigen Anordnung angeordnet sind. Jeder Haltevorrichtung ist jeweils eine Verschiebevorrichtung zugeordnet, so dass sämtliche Bauelement-Haltevorrichtungen unabhängig voneinander entlang einer gemeinsamen z-Achse verschoben werden können. In Figur 2 sind zwei Verschiebevorrichtungen, eine erste Verschiebevorrichtung 207a und eine zweite Verschiebevorrichtung 207b dargestellt. Dabei ist die erste Verschiebevorrichtung 207a in einer Seitenansicht und die zweite Verschiebevorrichtung 207b in einer Schnittansicht dargestellt. Die beiden Verschiebevorrichtung 207a und 207b sind in einem Abstand d voneinander angeordnet.

Der Bestückkopf 207 weist ein Grundelement bzw. ein Gehäuse 208 auf, welches eine Rahmenstruktur für die korrekte Anordnung der einzelnen Komponenten des Bestückkopfes 207 darstellt. Aus Gründen der Übersichtlichkeit ist das Gehäuse 208 lediglich unvollständig abgebildet.

In dem Gehäuse 208 ist ein Linearführungselement 260 um eine Längsachse 266 drehbar gelagert. Gemäß dem hier dargestellten Ausführungsbeispiel ist das Linearführungselement eine Hülse 260. Die Hülse weist an ihrem oberen Abschnitt eine Magnetrad 261 auf. Das Magnetrad 261 ist eine entlang der Längsachse aufgebaute Schichtstruktur, die eine Schicht aus einem permanentmagnetischen Material 261a aufweist. Die permanentmagnetische Schicht 261a ist zwischen zwei Schichten aus einem metallischen Material 261b, bevorzugt Eisen, eingebettet.

In dem Gehäuse sind ferner Drehantriebe 263 angeordnet, wobei jeweils ein Drehantrieb 263 einer Verschiebeeinrichtung 207a bzw. 207b zugeordnet ist. Die Drehantriebe 263 weisen jeweils ein Antriebsrad 264 auf, welches mit jeweils einem Magnetrad 261 derart magnetisch zusammenwirkt, dass bei einer Drehung des Antriebsrades 264 das entsprechende Magnetrad und damit auch die Hülse 260 um die jeweilige Längsachse 266 gedreht wird.

Die Hülsen 260 weisen jeweils eine Öffnung auf, die sich entlang der Längsachse 266 erstrecken. In der Öffnung ist ein länglicher Schaft 265 angeordnet, welcher häufig auch als Pinole bezeichnet wird. Der längliche Schaft 265 ist innerhalb der Öffnung entlang der z-Richtung verschiebbar gelagert. Um eine verdrehsichere Lagerung des Schafts 265 in der Hülse 260 zu gewährleisten, weist der längliche Schaft 265 entlang eines Längsabschnitts 268a einen Anschnitt 268 auf, der auch in der Querschnittsansicht senkrecht zur Längsachse 266 zu erkennen ist, welche Querschnittsansicht unten rechts in Figur 2 dargestellt ist. Innerhalb des Längsabschnitts 268a weist der längliche Schaft 265 somit eine Außenkontur 269 auf, die von einer Zylindersymmetrie abweicht. Ferner ist in der Öffnung der Hülse 260 ein Sperrelement 268b vorgesehen, so dass im Ergebnis die Innenkontur der Hülse 260 komplementär zu der Außenkontur 269 geformt ist. Auf diese Weise wird eine verschiebbare und trotzdem verdrehsichere Lagerung des länglichen Schafts 265 innerhalb der Hülse 260 erreicht.

An dem unteren Ende des länglichen Schafts 260 ist, wie unten links in Figur 2 dargestellt, eine Bauelement-Haltevorrichtung 220 angeordnet. Gemäß dem hier dargestellten Ausführungsbeispiel ist die Haltevorrichtung eine Saugpipette, welche bei einer entsprechenden Beaufschlagung mit einem Unterdruck ein elektronisches Bauelement 225 halten kann. Der zum Halten eines Bauelements 225 erforderliche Unterdruck wird über eine Vakuum-Zwischenkammer 292 und einen Saugkanal 290 von einer nicht dargestellten Vakuum-Erzeugungseinheit auf die Saugpipette 220 übertragen, die ebenfalls einen nicht dargestellten Saugkanal aufweist.

Um bei unterschiedlichen Höhenpositionen des länglichen Schafts 265 relativ zu der Hülse 260 eine zuverlässige pneumatische Kopplung zwischen der Vakuum-Zwischenkammer 292 und dem Saugkanal 290 zu gewährleisten, ist an der Außenseite des Schafts 265 eine Aussparung 291 vorgesehen. Die Aussparung 291 erstreckt sich dabei entlang der Längsachse 266, so dass unabhängig von der Höhenposition des Schafts 265 stets ein Teil der Aussparung einer Öffnung 293 der Vakuum-Zwischenkammer 292 gegenübersteht. Auf diese Weise ist stets ein durchgehender Saugkanal von der Vakuum-Zwischenkammer 292 hin zu der Saugpipette 220 gewährleistet.

Jede Verschiebevorrichtung weist ein Rückstellfederelement 285 auf, welches derart zwischen dem länglichen Schaft 265 und der Hülse 260 eingebaut ist, dass der längliche Schaft 265 durch die Federkraft des Rückstellfederelements 285 in eine obere Ausgangsposition gedrückt wird. Um eine Bewegung des länglichen Schafts 265 entlang der z-Richtung nach unten zu erzeugen, ist im oberen Teil des Bestückkopfes 207 für jeden länglichen Schaft jeweils ein Linearantrieb 275 vorgesehen. Dieser weist einen entlang der z-Achse verschiebbaren Antriebsstößel 276 auf, welcher bei einer Bewegung nach unten gegen eine obere plane Stirnfläche 267 des Schafts 265 drückt. Auf diese Weise kann der Schaft und die daran angebrachte Haltevorrichtung 220 relativ zu dem Gehäuse 208 des Bestückkopfes 207 nach unten bewegt werden.

Ein zentrale Krafteinleitung, bei der keine Transversalkräfte senkrecht zu der z-Achse auf den Schaft 265 ausgeübt werden, wird durch ein Koppelelement 280 erreicht, welches zwischen dem Antriebsstößel 276 und der planen Stirnfläche 267 geklemmt ist. Gemäß dem hier dargestellten Ausführungsbeispiel ist das Koppelelement eine Kugel 280. Das Anliegen der Kugel 280 an der planen Stirnfläche 267 hat den Vorteil, dass eine reibungsarme Punktbelastung realisiert werden kann. Damit kann zwischen dem nicht drehbar gelagerten Antriebsstößel 276 und dem Schaft 265 ein nahezu punktförmiger mechanischer Kontakt und damit eine weitgehend reibungsfreie Drehung des länglichen Schafts 265 realisiert werden. Auf diese Weise sind der Antriebsstößel 276 und der längliche Schaft 265 in Bezug auf Drehbewegungen um die Verschiebeachse bzw. um die z-Achse nahezu vollständig entkoppelt.

Eine zentrische Justierung der Kugel 280 wird gemäß dem hier dargestellten Ausführungsbeispiel dadurch realisiert, dass die Kugel 280 in einer Aussparung fixiert ist. Wie aus Figur 2 ersichtlich, ist die Aussparung in einem Kugelaufnahmeelement 277 ausgeformt, welches sich in dem Antriebsstößel 276 befindet. Infolge der durch die Rückstellfeder 285 erzeugten Klemmwirkung bleibt diese Justierung auch während des Betriebes des Bestückkopfes 207 zuverlässig erhalten.

Es wird darauf hingewiesen, dass die Aussparung auch an der Stirnfläche des Schafts 265 ausgebildet sein kann. Ein punktförmiger mechanischer Kontakt kann auch in diesem Fall auf einfache Weise realisiert werden, indem der Antriebsstößel 276 ein plane Stirnfläche aufweist, welche der Kugel zugewandt ist.

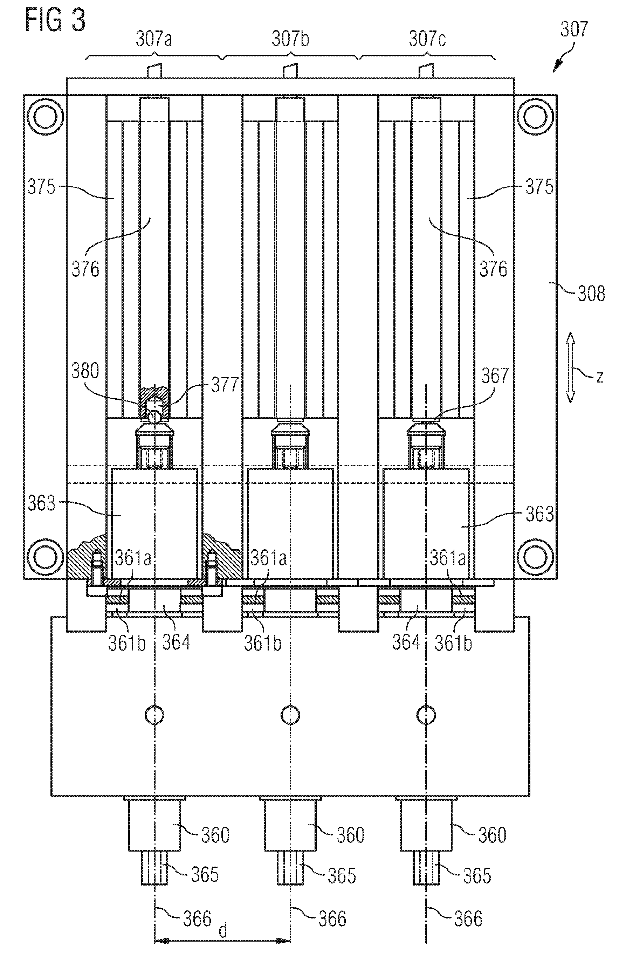

Figur 3 zeigt eine Frontansicht des in Figur 2 dargestellten Mehrfach-Bestückkopfes, welcher nunmehr mit dem Bezugszeichen 307 versehen ist. In Figur 3 sind drei Verschiebevorrichtungen, 307a, 307b und 307c dargestellt, die in einem Gehäuse 308 des Bestückkopfes in einem Abstand d voneinander angeordnet sind. Die verdrehsichere Lagerung eines länglichen Schafts 365 in einer Hülse 360 wurde bereits oben anhand von Figur 2 erläutert.

In der in Figur 3 dargestellten Frontansicht befinden sich die Drehantriebe 363 jeweils vor den Verschiebeachsen 366. Zu erkennen sind auch die Antriebsräder 364 der Drehantriebe 363 sowie die Magneträder, die, wie bereits oben im Detail beschrieben, eine Schichtanordnung bestehend aus einem permanentmagnetischen Material 361a und einem metallischen Material 361b aufweisen.

In der mit dem Bezugszeichen 307a gekennzeichneten Verschiebevorrichtung ist der Bereich um die Kugel 380 freigelegt, welche Kugel 380 das Koppelelement darstellt und welche an der planen Stirnfläche 367 des Schafts 365 anliegt. Das in dem Antriebsstößel 376 des Linearantriebs 375 angeordnete Kugelaufnahmeelement 377, welches eine Aussparung zur Zentrierung der Kugel 380 aufweist, ist zu erkennen.

Es wird darauf hingewiesen, dass die hier beschriebenen Ausführungsformen lediglich eine beschränkte Auswahl an möglichen Ausführungsvarianten der Erfindung darstellen. So ist es möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind.

### Bezugszeichenliste

- 100: Bestückautomat
- 101: Datenverarbeitungseinrichtung / Prozessor
- 102: Rahmen
- 103: stationäre Linearführungen
- 104: quer stehender Trägerarm
- 105: Linearführung
- 106: Halteelement
- 107: Bestückkopf
- 110: Bauelement-Zuführeinrichtung
- 112: Bauelement-Abholpositionen
- 120: Haltevorrichtung / Sauggreifer / Saugpipette
- 130: Bauelementeträger / Leiterplatte / Referenzebene
- 131: Förderband
- 132: Markierung
- 140: Leiterplatten-Kamera
- 150: Bauelemente-Kamera
- 151: Auswerteeinheit

- 207: Bestückkopf
- 207a: erste Verschiebevorrichtung
- 207b: zweite Verschiebevorrichtung
- 208: Grundelement / Gehäuse
- 220: Haltevorrichtung / Saugpipette
- 225: Bauelement
- 260: Linearführungselement / Hülse
- 261: Magnetrad
- 261a: permanentmagnetisches Material
- 261b: metallischen Material
- 263: Drehantrieb
- 264: Antriebsrad
- 265: länglicher hohler Schaft / Pinole
- 266: Längsachse / Verschiebeachse / Drehachse / z-Achse
- 267: plane Stirnfläche
- 268: Anschnitt
- 268a: Längsabschnitt mit Anschnitt
- 268b: Sperrelement

- 269: Außenkontor länglicher Schaft / Innenkontur Linearführungselement
- 275: Linearantrieb
- 276: Antriebsstößel
- 277: Kugelaufnahmeelement mit Aussparung für Kugel
- 280: Koppelelement / Kugel
- 285: Rückstellfederelement / Rückstellfeder
- 290: Saugkanal
- 291: Aussparung für Vakuum
- 292: Vakuum-Zwischenkammer
- 293: Öffnung
- d: Abstand zwischen benachbarte Verschiebeeinrichtungen

- 307: Bestückkopf
- 307a: erste Verschiebevorrichtung
- 307b: zweite Verschiebevorrichtung
- 307c: dritte Verschiebevorrichtung
- 308: Grundelement / Gehäuse
- 360: Linearführungselement / Hülse
- 361a: permanentmagnetisches Material
- 361b: metallischen Material
- 363: Drehantrieb
- 364: Antriebsrad
- 365: länglicher hohler Schaft / Pinole
- 366: Längsachse / Verschiebeachse / Drehachse / z-Achse
- 367: plane Stirnfläche
- 375: Linearantrieb
- 376: Antriebsstößel
- 377: Kugelaufnahmeelement mit Aussparung für Kugel
- 380: Koppelelement / Kugel
- d: Abstand zwischen benachbarte Verschiebeeinrichtungen

## Patentansprüche

1. Verschiebevorrichtung für eine Haltevorrichtung (220) für elektronische Bauelemente (225), die Verschiebevorrichtung (207a, 207b, 307a, 307b, 307c) aufweisend
• ein Grundelement (208, 308),
• ein Linearführungselement (260, 360), welches an dem Grundelement (208, 308) angeordnet ist,
• einen länglichen Schaft (265, 365),
welcher entlang seiner Längsachse (266, 366), die parallel zu einer z-Achse ausgerichtet ist, in einer Öffnung des Linearführungselements (260, 360) verschiebbar gelagert ist, und
welcher an einem Ende zur Aufnahme der Haltevorrichtung (220) eingerichtet ist,
• einen Linearantrieb (275, 375),
welcher an dem Grundelement (208, 308) angeordnet ist und welcher zum Verschieben des länglichen Schafts (265, 365) entlang der z-Achse eingerichtet ist, und
• ein Koppelelement (280, 380), welches zwischen dem Linearantrieb (275, 375) und dem länglichen Schaft (265, 365) angeordnet ist, wobei
das Koppelelement (280, 380) derart ausgebildet ist, dass von dem Linearantrieb (275, 375) auf den länglichen Schaft (265, 365) lediglich Kräfte entlang der z-Achse übertragbar sind.

2. Verschiebevorrichtung nach Anspruch 1, zusätzlich aufweisend
• ein Rückstellfederelement (285, 385), welches den länglichen Schaft (265, 365) relativ zu dem Grundelement (208, 308) in eine Ausgangsstellung drückt, und
• einen dem Linearantrieb (275, 375) zugeordneten Antriebsstößel (276, 376), mit dem der längliche Schaft (265, 365) aus seiner Ausgangsstellung entlang der z-Achse auslenkbar ist.

3. Verschiebevorrichtung nach Anspruch 2, bei der das Koppelelement eine Kugel (280, 380) ist.

4. Verschiebevorrichtung nach einem der Ansprüche 2 bis 3, bei der
der Antriebsstößel (276, 376) oder der längliche Schaft (254, 365) eine plane Stirnfläche (267, 367) aufweist, an der das Koppelelement (280, 380) anliegt.

5. Verschiebevorrichtung nach einem der Ansprüche 1 bis 4, bei der
• das Linearführungselement (260, 360) eine relativ zu dem Grundelement (208, 308) um die z-Achse drehbar gelagerte Hülse (260, 360) ist und
• eine Innenkontur (269) des Linearführungselements (260) derart mit einer Außenkontur (269) des längliche Schafts (265) zusammenwirkt, dass bei einer Drehung des Linearführungselements (260) um die z-Achse der längliche Schaft (265) in gleicher Weise wie das Linearführungselement (260) um die z-Achse gedreht wird.

6. Verschiebevorrichtung nach Anspruch 5, zusätzlich aufweisend
einen Drehantrieb (263, 363), welcher mit dem Linearführungselement (260, 360) über zumindest ein Magnetrad (261, 361a, 361b) gekoppelt ist.

7. Bestückkopf zum automatischen Bestücken von Bauelementeträgern (130) mit elektronischen Bauelementen (225), der Bestückkopf (107, 207, 307) aufweisend
• zumindest eine Verschiebevorrichtung (207a, 207b, 307a, 307b, 307c) nach einem der Ansprüche 1 bis 6.

8. Vorrichtung zum automatischen Bestücken von Bauelementeträgern (130) mit elektronischen Bauelementen (225), die Vorrichtung aufweisend
• zumindest einen Bestückkopf (107, 207, 307) nach Anspruch 7.
